Europäisches Patentamt

European Patent Office

Office européen des brevets

(19)

(11) **EP 1 236 049 B1**

(12) **EUROPÄISCHE PATENTSCHRIFT**

(45) Veröffentlichungstag und Bekanntmachung des Hinweises auf die Patenterteilung:
**14.05.2003 Patentblatt 2003/20**

(21) Anmeldenummer: **00988760.5**

(22) Anmeldetag: **27.11.2000**

(51) Int Cl.⁷: $G01R\ 17/16$

(86) Internationale Anmeldenummer:
**PCT/EP00/11806**

(87) Internationale Veröffentlichungsnummer:
**WO 01/040813 (07.06.2001 Gazette 2001/23)**

(54) **MESSBRÜCKENSCHALTUNG IN DREILEITERTECHNIK MIT SPEISESPANNUNGSNACHREGELUNG**

MEASURING BRIDGE CIRCUIT IN THREE WIRE TECHNOLOGY AND PROVIDED WITH SUPPLY VOLTAGE REGULATION

CIRCUIT DE PONT DE MESURE SELON LA TECHNIQUE A TROIS CONDUCTEURS ET PRESENTANT UN SYSTEME DE REGULATION DE LA TENSION D'ALIMENTATION

(84) Benannte Vertragsstaaten:
**AT BE CH CY DE DK ES FI FR GB GR IE IT LI LU MC NL PT SE TR**

(30) Priorität: **29.11.1999 DE 19957088**

(43) Veröffentlichungstag der Anmeldung:
**04.09.2002 Patentblatt 2002/36**

(73) Patentinhaber: **Hottinger Baldwin Messtechnik GmbH**
**64293 Darmstadt (DE)**

(72) Erfinder:
• **KREUZER, Manfred**
**64331 Weiterstadt (DE)**

• **KITZING, Herbert**
**64347 Griesheim (DE)**

(74) Vertreter: **Behrens, Helmut, Dipl.-Ing. et al**
**Gross-Gerauer Weg 55**
**64295 Darmstadt (DE)**

(56) Entgegenhaltungen:
**US-A- 5 814 995**

• **DATABASE WPI Week 199614 Derwent Publications Ltd., London, GB; AN 1996-138245 XP002167386 & RU 2 039 956 C (VILIN YU), 20. Juli 1995 (1995-07-20)**

EP 1 236 049 B1

**Beschreibung**

Die Erfindung betrifft eine Meßbrückenschaltung in Dreileitertechnik gemäß dem Oberbegriff des Patentanspruchs 1.

Beim Einsatz von Dehnungsmeßstreifen zur Meßwerterfassung werden diese meist mit Kompensationsdehnungsmeßstreifen oder Ergänzungswiderständen zu einer Wheatstone'schen-Brücke verschaltet. Insbesondere wenn Einzeldehnungsmeßstreifen über längere Leitungswege mit den übrigen Brückenzweigen zu einer sogenannten 1/4-Brücke verbunden werden, können die Leitungswiderstände zu Spannungsabfällen führen, die die Meßgenauigkeit erheblich beeinträchtigen. Dabei hängen die Spannungsabfälle im wesentlichen von den Leitungslängen zwischen den Dehnungsmeßstreifen und den übrigen Ergänzungswiderständen und auch von den Umgebungstemperaturen ab. Bei Meßaufgaben, bei denen es nicht möglich oder sinnvoll ist, die Dehnungsmeßstreifen in der Nähe der Brückenergänzung anzuordnen, kann der Einfluß dieser Spannungsabfälle durch schaltungstechnische Maßnahmen minimiert werden.

Aus dem Rohrbach, Handbuch für experimentelle Spannungsanalyse, Düsseldorf 1999, Seiten 674 bis 676 ist eine Viertel-Brücke in sogenannter Dreileitertechnik vorbekannt, durch die derartige Spannungsabfälle in den Anschlußleitungen meßtechnisch berücksichtigt werden. Dazu wird der Dehnungsmeßstreifen über zwei Zuleitungen mit den Ergänzungswiderständen und der Speisespannungsquelle verbunden. Über eine dritte Anschlußleitung wird in die Meßdiagonale der Brücke ein Operationsverstärker geschaltet, so daß dadurch die beiden Spannungsabfälle in verschiedenen Brückenzweigen wirksam werden und sich bei gleicher Größe kompensieren. Hierdurch werden zwar die Nullpunktfehler vermieden, aber der Einfluß auf die Empfindlichkeit kann damit nicht beseitigt werden.

Aus dem Rohrbach, Handbuch für experimentelle Spannungsanalyse, Seite 676 ist eine sogenannte Vierleiterschaltung vorbekannt, mit der eine derartige Empfindlichkeitsminderung vermieden wird. Dazu ist ein in Viertelbrückenschaltung befindlicher Dehnungsmeßstreifen über vier Zuleitungen mit den übrigen Brückenelementen verbunden, wobei der Spannungsabfall auf der einen Speiseleitung durch einen Operationsverstärker zwischen der Speiseleitung und einer Fühlerleitung ausgeglichen wird. Weiterhin sind zwischen einer weiteren Speiseleitung und einer Meßleitung noch zwei Operationsverstärker vorgesehen, die den Spannungsabfall auf der zweiten Speiseleitung gleichmäßig auf die beiden Brückenzweige verteilen und die Speisespannung um den Spannungsabfall auf dieser Speiseleitung entsprechend erhöhen, so daß auch die Empfindlichkeitseinbuße vermieden wird.

Aus dem Rohrbach, Handbuch für experimentelle Spannungsanalyse, Seite 659 und 676 sind noch weitere sechs Viertelbrückenschaltungen mit Dehnungsmeßstreifen vorbekannt, die in Vierleitertechnik ausgeführt sind und alle sowohl die Spannungsabfälle als auch den Empfindlichkeitsverlust ausgleichen. Allerdings gibt es häufig Anwendungsfälle, bei denen sehr große Meßstellenzahlen vorkommen, wie z. B. bei der Strukturanalyse von Flugzeugteilen, wo der Leitungsaufwand durch die Vierleitertechnik sehr groß wird.

Der Erfindung liegt deshalb die Aufgabe zugrunde, eine Meßbrückenschaltung mit Einzeldehnungsmeßstreifen zu schaffen, durch die auch längere Anschlußleitungen kompensierbar sind und dies bei geringstem Aufwand.

Diese Aufgabe wird durch die im Patentanspruch 1 angegebene Erfindung gelöst. Weiterbildungen und vorteilhafte Ausführungsbeispiele sind in den Unteransprüchen angegeben.

Die Erfindung hat den Vorteil, daß ohne einen großen Verkabelungsaufwand mit einfachen Mitteln die Nullpunktstabilität und nahezu die Empfindlichkeit einer Vierleiterschaltung erreichbar ist. Dabei hat sich insbesondere als vorteilhaft erwiesen, daß bereits in Dreileitertechnik verkabelte Versuchsaufbauten mit z. T. vielen hundert Meßstellen mit erhöhten Meßgenauigkeiten nutzbar sind. Weiterhin hat sich hierbei als vorteilhaft erwiesen, daß auch die Bauelementeanzahl gegenüber der Vierleiterschaltung verringerbar ist, da die Erfindung lediglich mit einer zusätzlichen Verstärker- und Addierschaltung gegenüber der bisherigen Dreileitertechnik ausführbar ist. Deshalb sind auf dem gleichen Schaltungsplatinenraum wesentlich größere Anzahlen von Meßkanälen unterbringbar, wodurch vorteilhafterweise eine Platz- und Kostenersparnis erreichbar ist.

Weiterhin besitzt die Erfindung den Vorteil, daß durch die Speisespannungsregelung auch Temperaturänderungen während eines Meßvorgangs berücksichtigt werden können, so daß hierdurch ein Empfindlichkeitsverlust vermeidbar ist. Dies ist insbesondere bei Dehnungsmessungen an Flugzeugteilen vorteilhaft, die häufig bei Temperaturschwankungen von mehr als 100 °C durchgeführt werden, wodurch eine Verfälschung der Meßergebnisse vermeidbar ist.

Bei der Erfindung ist weiterhin von Vorteil, daß nicht nur Leitungswiderstände in den Anschlußleitungen, sondern auch Schaltwiderstände ausgleichbar sind, so daß auch hierdurch ein Empfindlichkeitsverlust vermeidbar ist. Insbesondere bei Schaltungen mit verschiedenen Ergänzungswiderständen, die über Halbleiterschaltungen mit mehreren Ohm Schaltwiderstandswerten zuschaltbar sind, können gleichzeitig auch diese Schaltwiderstände mit kompensiert werden.

Bei einer besonderen Ausführungsart der Erfindung, bei der die Spannungsquelle am Nullpunkt bei der halben Speisespannung geerdet ist, ist vorteilhaft, daß die Spannungsregelung auf einfache Weise nur auf einer Halbseite der Speisespannung nachregelbar ist. Hierdurch ist ein erheblicher Aufwand an Bauelementen und an Geräteraum einsparbar.

Die Erfindung wird anhand eines Ausführungsbeispiels, das in der Zeichnung dargestellt ist, näher erläutert. Es zeigen:

Fig. 1: eine Meßbrückenschaltung in Dreileitertechnik mit Speisespannungsnachregelung und

Fig. 2: eine Mehrkanal-Meßbrückenschaltung mit zuschaltbaren Ergänzungswiderständen und asymmetrischer Speisespannungsnachregelung.

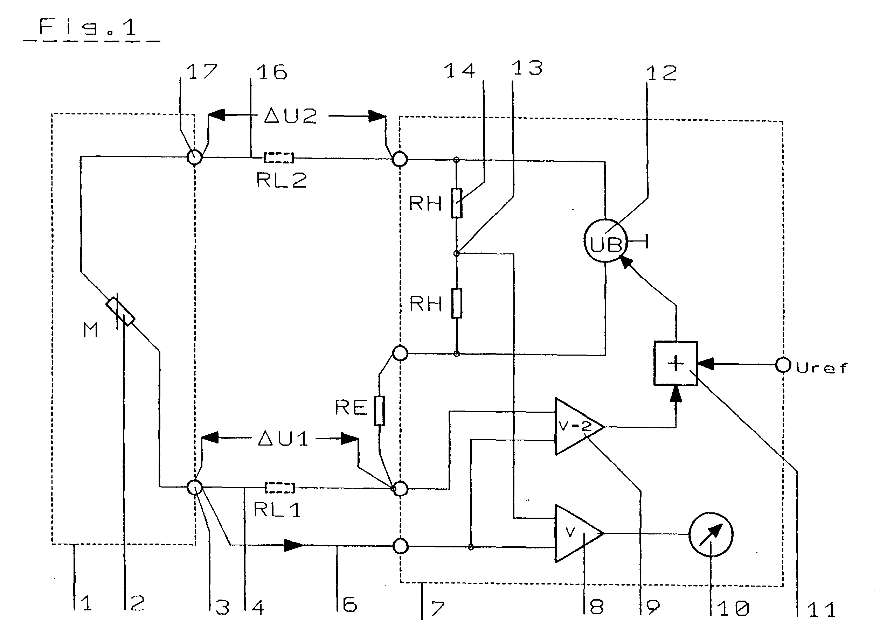

In Fig. 1 der Zeichnung ist eine Meßbrückenschaltung mit einem Dehnungsmeßstreifen 1 in ¼-Brückenschaltung dargestellt, der über drei Anschlußleitungen 4, 6, 16 mit den weiter entfernt angeordneten Brückenzweigen in einem Auswertegerät 7 verbunden ist, an die eine Speisespannungsregelung angeschlossen ist.

Die Brückenschaltung besteht im wesentlichen aus einem Dehnungsmeßstreifen 1, der als veränderbarer Widerstand M dargestellt ist. Dieser Dehnungsmeßstreifen 1 ist an einem nicht dargestellten zu messenden Bauteil befestigt. Dabei wird in der Regel die Dehnung dieses belasteten Bauteils in einem Versuchsaufbau gemessen. In der Praxis können deshalb einige hundert dieser Dehnungsmeßstreifen 1 an dem zu untersuchenden Bauteil angebracht sein, die dann mit den weiter entfernt angeordneten Auswertegeräten 7 verbunden sind. Jeder Dehnungsmeßstreifen 1 ist zur Erfassung der Dehnung als 1/4-Brücke 2 geschaltet und über zwei Anschlüsse 3, 17 mit drei Anschlußleitungen 4, 6, 16 mit der übrigen Meßbrückenschaltung verbunden. Dabei können die Anschlußleitungen 4, 6, 16 auch bis zu einigen hundert Metern Länge betragen und sind deshalb aus Kosten- und Platzgründen meist aus dünnen Kupferleitungen gefertigt. Da zwei Anschlußleitungen 4, 16 zur Speisung des Dehnungsmeßstreifens 1 dienen, verursachen diese Kupferleitungen durch ihre Leitungswiderstände $R_{L1}$ und $R_{L2}$ die Spannungsabfälle $\Delta U_1$ und $\Delta U_2$. Diese beiden Anschlußleitungen 4, 16 sind mit einem Meßkanal in den Auswertegeräten 7 verbunden, der im wesentlichen aus den übrigen Brückenzweigen und der Speisespannungsregelung besteht.

Der Dehnungsmeßstreifen 1 ist über eine erste Anschlußleitung 4 mit einem Ergänzungswiderstand $R_E$ zu einer ½-Brücke verschaltet. Über die zweite Anschlußklemme 17 des Dehnungsmeßstreifens 1 ist eine zweite Anschlußleitung 16 geschaltet, die mit einer zweiten Halbbrücke 14 und einer Speisespannungsquelle 12 verbunden ist. Die zweite Halbbrücke 14 besteht aus zwei Festwiderständen $R_H$, die gleiche Widerstandswerte besitzen. Beide Halbbrücken sind zu einer Vollbrücke verschaltet, an der die Speisespannung $U_B$ anliegt.

In der Meßdiagonalen 3, 13 der Vollbrücke, die eine Wheatstone'sche Brücke darstellt, ist eine erste hochohmige Verstärkerschaltung 8 vorgesehen, die als Operationsverstärker ausgebildet ist. Am Ausgang dieses Operationsverstärkers 8 liegt der Meßwert der Brückenschaltung an, der in einem Anzeigegerät 10 darstellbar oder sonst in weiteren nicht dargestellten Rechenschaltungen weiterverarbeitbar ist.

Die erste Verstärkerschaltung 8 ist mit dem einen Anschluß 3 über die dritte Anschlußleitung 6 mit den Dehnungsmeßstreifen 1 und mit dem anderen Anschluß 13 mit der Festwiderstandshalbbrücke verbunden. Dadurch greift die erste Verstärkerschaltung 8 die Diagonalbrückenspannung ab, und verstärkt diese anzeigbar, ohne daß dabei ein berücksichtigbarer Strom fließt. Dieser Teil der Schaltung stellt im wesentlichen den Stand der Technik einer Dreileiterschaltung dar, durch die sich die Spannungsabfälle $\Delta U_1$ und $\Delta U_2$ kompensieren, da sie sich auf die beiden Brückenzweige gleichmäßig aufteilen. Eine Derartige Aufteilung kann auch nur zu geringen Meßfehlern führen, da diese speziellen Dreileitermeßleitungen nahezu identisch sind.

Zur Vermeidung des Empfindlichkeitsverlustes ist zwischen der ersten Anschlußleitung 4 und der dritten Anschlußleitung 6 eine zweite hochohmige Verstärkerschaltung 9 vorgesehen, die den Spannungsverlust auf der ersten Anschlußleitung 4 erfaßt. Diese zweite Verstärkerschaltung 9 besitzt einen Verstärkungsfaktor v = 2, der den Spannungsabfall auf den beiden gleich ausgebildeten Anschlußleitungen 4, 16 kompensiert. Bei unterschiedlichen Anschlußleitungen kann mittels eines Kalbriervorgangs oder durch rechnerische Verfahren auch ein anderes Verhältnis der Spannungsabfälle ermittelt und durch entsprechende Einstellung des Verstärkungsfaktors kompensiert werden.

Die am Ausgang des zweiten Verstärkers 9 anliegende Spannung, die der Summe der Spannungsabfälle aus den beiden Anschlußleitungen 4, 16 entspricht, wird nachfolgend einer Additionsschaltung 11 zugeführt. An der Additionsschaltung 11 liegt gleichzeitig eine Referenzspannung $U_{ref}$ an, die der Speisespannung $U_B$ ohne Anschlußleitungsverluste entspricht. Durch die Additionsschaltung 11 wird der Leerlaufbrückenspannung $U_{ref}$ die am Ausgang der zweiten Verstärkerschaltung 9 anliegende Spannung zuaddiert, so daß die Speisespannung um die Summe der Spannungsverluste auf den Anschlußleitungen 4, 16 erhöht wird. Hierdurch wird die Speisespannung stets um die Spannungsverluste zwischen dem Dehnungsmeßstreifen 1 und den übrigen Brückenzweigen kompensiert. Dadurch sind nicht nur die Leitungsverluste $\Delta U_1$, $\Delta U_2$, sondern auch Schaltwiderstandsverluste ausgleichbar, so daß dadurch kein Empfindlichkeitsverlust eintritt. Eine derartige Speisespannungsnachregelung berücksichtigt auch Widerstandsänderungen, die während des Meßvorgangs auftreten, wie beispielsweise temperaturbedingte Widerstandsänderungen in den Meßleitungen aufgrund von Temperaturschwankungen.

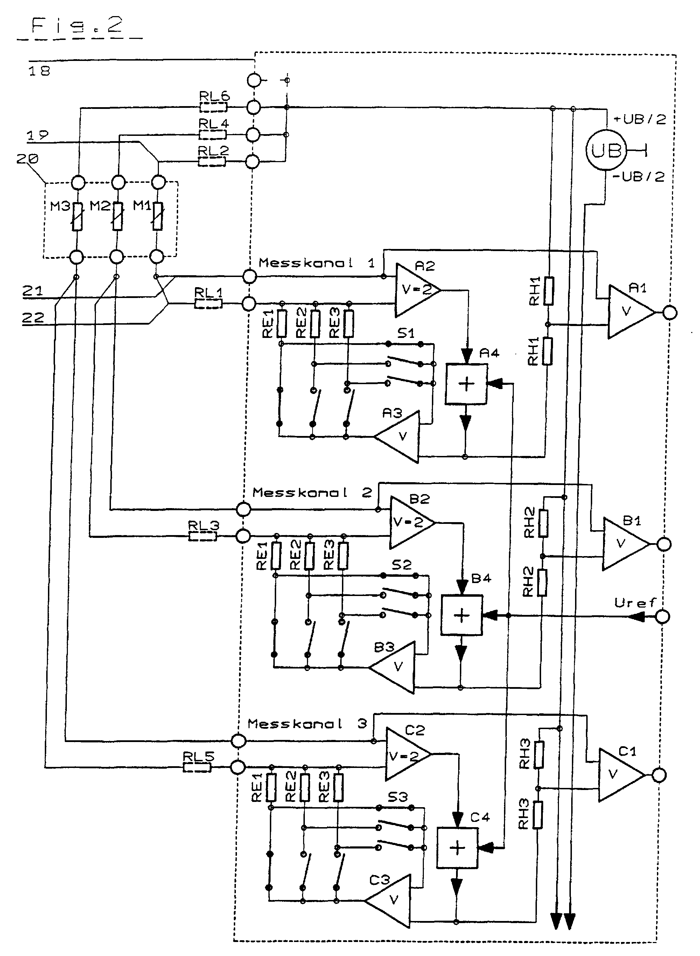

In Fig. 2 der Zeichnung ist eine Mehrkanalmeßbrückenschaltung mit zuschaltbaren Ergänzungswiderständen $R_{E1}$, $R_{E2}$, $R_{E3}$ und asymmetrischer Speisespannungsnachregelung dargestellt. In der Praxis der Vielstellenmeßtechnik mit Dehnungsmeßstreifen $M_1$, $M_2$, $M_3$ wird die ¾-Brücke aus den Festwiderständen meist ortsfest in den Auswertegeräten 18 angeordnet, während die Dehnungsmeßstreifen $M_1$, $M_2$, $M_3$ direkt am Meßobjekt befestigt sind und über Anschlußleitungen 19, 21, 22 mit der übrigen Brücke verbunden werden. Dabei sind die Auswertegeräte 18 meist so ausgeführt, daß sie eine Vielzahl von Meßkanälen aufweisen, an die jeweils ein Dehnungsmeßstreifen $M_1$, $M_2$, $M_3$ anschließbar ist. Da in der Praxis Dehnungsmeßstreifen $M_1$, $M_2$, $M_3$ mit unterschiedlichen Anschlußwiderstandswerten gebräuchlich sind, müssen in den Meßgeräten 18 auch unterschiedliche Ergänzungswiderstände $R_{E1}$, $R_{E2}$ und $R_{E3}$ vorgesehen werden. Die Ergänzungswiderstände $R_{E1}$, $R_{E2}$, $R_{E3}$ werden dann meist über Halbleiterschalter $S_1$, $S_2$, $S_3$ zugeschaltet, die zusätzlich berücksichtigt werden müssen, um nicht einen zusätzlichen Spannungsverlust zu verursachen.

In der Zeichnung ist eine dreikanalige Meßanordnung dargestellt, die in der Praxis z. B. für eine Dehnungsmeßstreifenrosette 20 vorgesehen ist. Die einzelnen Dehnungsmeßstreifen derartiger Dehnungsmeßstreifenrosetten 20 sind häufig an einem Ende fest verbunden und erfassen den Dehnungsbereich eines Bauteils in 120° versetzten Richtungen, so daß damit die Flächenbelastung nach allen Richtungen feststellbar ist. Für eine mehrkanalige Meßanordnung sind aber auch eine Vielzahl von Einzeldehnungsmeßstreifen denkbar, die bestimmte Dehnungsbereiche am zu unersuchenden Bauteil erfassen.

Die Dehnungsmeßstreifenrosetten 20 bestehen aus den drei Dehnungsmeßstreifen $M_1$, $M_2$ und $M_3$, die über Meß- und Verbindungsleitungen 19, 21, 22 mit den Meßkanälen verbunden sind. Dabei sind die Anschlußleitungen 19, 22 als Leitungswiderstände $R_{L1}$ bis $R_{L6}$ dargestellt, deren Verlustwerte kompensiert werden müssen. Als dritte Anschlußleitung 21 jedes Meßkanals ist eine Leitung zwischen dem Ausgang der Dehnungsmeß.streifen $M_1$ und einer hochohmigen Verstärkerschaltung $A_1$ vorgesehen. Jeder Meßkanal ist im Grunde so ausgebildet, wie die Meßbrückenschaltung nach Fig. 1 der Zeichnung. Dabei unterscheidet sind jeder Meßkanal lediglich dadurch, daß noch zwei zusätzliche Ergänzungswiderstände $R_{E2}$ und $R_{E3}$ vorgesehen sind, die über Halbleiterschalter $S_1$ an die Additionsschaltung $A_4$ anschaltbar sind. Dabei werden die Schaltwiderstände $S_1$, $S_2$ bzw. $S_3$ über einen zusätzlichen Operationsverstärker $A_3$, $B_3$ bzw. $C_3$ kompensiert. Darüber hinaus benutzt das Ausführungsbeispiel nach Fig. 2 der Zeichnung eine Brückenspannungsquelle , deren Nullpunkt bei $\frac{U_B}{2}$ xgeerdet ist, so daß eine Speisespannung $U_B$ an der Brückenspannung aus den Spannungen $+ \frac{U_B}{2}$ und $- \frac{U_B}{2}$ anliegt. Dabei besitzt das Ausführungsbeispiel nach Fig. 2 der Zeichnung eine Speisespannungsnachregelung auf nur einer Spannungshalbseite bei $- \frac{U_B}{2}$, so daß dafür auch nur auf dieser Halbseite Bauelemente zur Kompensation notwendig sind. Im übrigen entspricht die Verstärkerschaltung $A_2$, $B_2$ bzw. $C_2$ der zweiten Verstärkerschaltung 9 und die Verstärkerschaltung $A_1$, $B_1$ bzw. $C_1$ der ersten Verstärkerschaltung 8 des Ausführungsbeispiels nach Fig. 1 der Zeichnung.

Werden an den fest verdrahteten Meßkanal 1 der Auswerteschaltung 18 beispielsweise ein externer Dehnungsmeßstreifen $M_1$ von 120 $\Omega$ angeschlossen, wird der dafür vorgesehene Ergänzungwiderstand $R_{E1}$ mittels elektronischer Schalter $S_1$ zugeschaltet. Bei der Verwendung anderer Dehnungsmeßstreifen mit anderen Widerstandswerten werden beispielsweise die Ergänzungswiderstände $R_{E2}$ oder $R_{E3}$ zugeschaltet. Sollten hingegen noch weitere Dehnungsmeßstreifen mit anderen Widerstandswerten zuschaltbar sein, so wären noch weitere Ergänzungswiderstände vorzusehen. Da die Halbleiterschalter $S_1$, $S_2$ bzw. $S_3$ nicht zu vernachlässigende Schaltwiderstandswerte besitzen, werden die dort anfallenden Spannungsabfälle durch den Operationsverstärker $A_3$ kompensiert.

Die Widerstände der Anschlußleitungen 19, 22 führen zu Spannungsabfällen, die das Meßergebnis verfälschen würde. Die üblichen Meßleitungen aus Kupferdraht haben einen recht großen Temperaturgradienten, so daß bei Anwendungen, bei denen das Kabel starken Temperaturänderungen ausgesetzt wird, ein unzulässig großer Meßfehler entstehen würde. Der Spannungsabfall der Leitung wird durch die hochohmige Verstärkerschaltung $A_2$ zwischen den Anschlußleitungen 21, 22 abgegriffen und mit dem Verstärkungsfaktor 2 verstärkt, um auch den Spannungsabfall auf der Leitung 19 mit dem gleichen Widerstandswert $R_{L2}$ zu berücksichtigen. Die heiden Leitungsspannungsabfälle $R_{L1}$ und $R_{L2}$ werden mittels einer Additionsschaltung $A_4$ der Speisespannungshälfte $- \frac{U_B}{2}$ aufaddiert, so daß die Speisespannung um die Leitungs- und Schaltungsspannungsabfälle nachgeregelt wird. Diese asymmetrische Speisespannungsnachregelung erfolgt während des gesamten Meßvorgangs, auch wenn sich die Leitungswiderstände $R_{L1}$ bis $R_{L6}$ in Folge von Temperaturschwankungen während des Meßvorgangs ändern sollten, so daß am Ausgang des Verstärkers $A_1$ stets ein genauer Meßwert anliegt, der sehr genau der erfolgten Dehnung am Dehnungsmeßstreifen $M_1$ entspricht.

Dieser Meßwert ist dann in nicht dargestellten Anzeigevorrichtungen anzeigbar oder in weiteren Rechenschaltungen weiterverarbeitbar.

Die übrigen Meßkanäle 2 und 3 sind in Ihrer Funktion und im Aufbau dem Meßkanal 1 identisch, so daß auf einfache Weise die Dehnung bei einer Vielzahl von Meßstellen sehr genau erfaßt und ausgewertet werden kann. Eine derartige Schaltung ist sowohl in Gleichstromtechnik als auch in Trägerfrequenztechnik ausführbar. Die ausgebbaren Meßwerte am Ausgang der Verstärkerschaltung $A_1$, $B_1$ bzw. $C_1$ können sowohl analog als auch digital erfolgen.

**Patentansprüche**

1.  Meßbrückenschaltung in Dreileitertechnik mit mindestens einem Dehnungsmeßstreifen (1, 20) in ¼-Brückenschaltung, der über eine erste Anschlußleitung (4, 22) mit einem Ergänzungswiderstand ($R_E$, $R_{E1}$, $R_{E2}$, $R_{E3}$) und einer zweiten Anschlußleitung (16, 19) mit einer Speisespannungsquelle (12) in Verbindung steht, wobei eine dritte Anschlußleitung (6, 21) vorgesehen ist, die mit einer hochohmigen ersten Verstärkerschaltung (8) in der Meßdiagonalen verbunden ist, **dadurch gekennzeichnet, daß** zwischen der ersten Anschlußleitung (4) und der dritten Anschlußleitung (6) eine zweite hochohmige Verstärkerschaltung (9) mit einem Verstärkungsfaktor v = 2 vorgesehen ist, die zur Nachregelung der Speisespannung ($U_B$) dient.

2. Meßbrückenschaltung nach Anspruch 1, **dadurch gekennzeichnet, daß** die am Ausgang der zweiten Verstärkerschaltung (9) anliegende Spannung in einer Additionsschaltung (11) zu einer Referenzspannung ($U_{ref}$) addiert wird, und daß die Summerspannung dann als nachgeregelte Speisespannung an der Brückenschaltung anliegt.

3. Meßbrückenschaltung nach Anspruch 1 oder 2, **dadurch gekennzeichnet, daß** die Speisespannungsquelle (12) im Nullpunkt bei der Hälfte der Speisespannung ($U_B/2$) geerdet ist und daß die Speisespannungsnachregelung auf einer Spannungshalbseite erfolgt.

4. Meßbrückenschaltung nach einem der vorhergehenden Ansprüche, **dadurch gekennzeichnet, daß** die dehnungsmeßstreifenseitige Halbbrücke durch verschiedene zuschaltbare Ergänzungswiderstände ($R_{E1}$, $R_{E2}$, $R_{E3}$) gebildet ist.

5. Meßbrückenschaltung nach Anspruch 4, **dadurch gekennzeichnet, daß** die Ergänzungswiderstände ($R_{E1}$, $R_{E2}$, $R_{E3}$) durch Halbleiterschalter ($S_1$, $S_2$, $S_3$) zuschaltbar sind, deren Schaltwiderstände durch eine zusätzliche dritte Verstärkerschaltung ($A_3$, $B_3$, $C_3$) kompensiert werden.

6. Meßbrückenschaltung nach einem der vorhergehenden Ansprüche, **dadurch gekennzeichnet, daß** für eine Vielzahl von Dehnungsmeßstreifen ($M_1$, $M_2$, $M_3$) eine Vielzahl von identischen Meßkanälen vorgesehen ist, wobei jeder Kanal über eine separate Speisespannungsnachregelung ($A_2$, $B_2$, $C_2$) verfügt.

## Claims

1. A test bridge circuit using three-wire techniques including at least one resistance strain gauge (1, 20) in a ¼-bridge circuit which is connected via a first connecting lead (4, 22) to a supplementary resistor ($R_E$, $R_{E1}$, $R_{E2}$, $R_{E3}$) and via a second connecting lead (16, 19) to a feed voltage source (12), wherein there is provided a third connecting lead (6, 21) which is connected to a first high impedance amplifier circuit (8) in the measuring diagonals, **characterised in that** a second high impedance amplifier circuit (9) having an amplification factor of v = 2 is provided between the first connecting lead (4) and the third connecting lead (6) and serves for adjusting the feed voltage ($U_B$).

2. A test bridge circuit in accordance with Claim 1, **characterised in that** the voltage present at the output of the second amplifier circuit (9) is added to a reference voltage ($U_{ref}$) in an adding circuit (11), and **in that** the sum voltage is then applied in the form of an adjusted feed voltage to the bridge circuit.

3. A test bridge circuit in accordance with Claim 1 or 2, **characterised in that** the feed voltage source (12) is earthed at the zero point at half the feed voltage ($U_B/2$), and **in that** the adjustment of the feed voltage is effected at one half-side of the voltage.

4. A test bridge circuit in accordance with any of the preceding Claims, **characterised in that** the resistance strain gauge portion of the half bridge is formed by different switchable supplementary resistors ($R_{E1}$, $R_{E2}$, $R_{E3}$).

5. A test bridge circuit in accordance with Claim 4, **characterised in that** the supplementary resistors ($R_{E1}$, $R_{E2}$, $R_{E3}$) are adapted to be switched in by means of semiconductor switches ($S_1$, $S_2$, $S_3$) whose switching resistances are compensated by means of an additional third amplifier circuit ($A_3$, $B_3$, $C_3$).

6. A test bridge circuit in accordance with any of the preceding Claims, **characterised in that**, for a plurality of resistance strain gauges ($M_1$, $M_2$, $M_3$), there are provided a plurality of identical test channels and each channel is provided with a separate feed voltage adjusting means ($A_2$, $B_2$, $C_2$).

## Revendications

1. Circuit de mesure en pont selon la technique à trois conducteurs comportant au moins une bande de mesure d'allongement (1, 20) dans un circuit en pont (1/4), qui est en liaison, par une première ligne de connexion (4, 22), avec une résistance complémentaire ($R_E$, $R_{E1}$, $R_{E2}$, $R_{E3}$) et une deuxième ligne de connexion (16, 19) avec une source de tension d'alimentation (12), une troisième ligne de connexion (6, 21), qui est reliée à un premier circuit d'amplificateur (8) de grande valeur ohmique dans la diagonale de mesure étant prévue, **caractérisé en ce qu'**il est prévu, entre la première ligne de connexion (4) et la troisième ligne de connexion (6), un deuxième circuit d'amplificateur (9) de grande valeur ohmique avec un premier facteur d'amplification (v = 2), qui sert à la régulation ultérieure de la tension d'alimentation ($U_B$).

2. Circuit de mesure en pont selon la revendication 1, **caractérisé en ce que** la tension qui s'applique à la sortie du deuxième circuit amplificateur (9) est additionnée, dans un circuit d'addition (11), pour donner une tension de référence ($U_{ref}$) et **en ce que** la tension totale s'applique alors, en tant que tension d'alimentation régulée ultérieurement, au circuit en pont.

3. Circuit de mesure en pont selon la revendication 1 ou 2, **caractérisé en ce que** la source de tension d'alimentation 12 est mise à la terre au point zéro à la moitié de la tension d'alimentation ($U_B/2$) et **en ce que** la régulation ultérieure de la tension d'alimentation s'effectue sur un demi-côté de la tension.

4. Circuit de mesure en pont selon l'une des revendications précédentes, **caractérisé en ce que** le demi-pont du côté de la bande de mesure d'allongement est formé par différentes résistances complémentaires ($R_{E1}$, $R_{E2}$, $R_{E3}$) qui peuvent être mises en circuit.

5. Circuit de mesure en pont selon la revendication 4, **caractérisé en ce que** les résistances complémentaires ($R_{E1}$, $R_{E2}$, $R_{E3}$) peuvent être mises en circuit par des interrupteurs à semi-conducteurs ($S_1$, $S_2$, $S_3$) dont les résistances de commutation sont compensées par un troisième circuit d'amplificateur ($A_3$, $B_3$, $C_3$) supplémentaire.

6. Circuit de mesure en pont selon l'une des revendications précédentes, **caractérisé en ce que** pour un grand nombre de bandes de mesures d'allongement ($M_1$, $M_2$, $M_3$) il est prévu un grand nombre de canaux de mesure identiques, chaque canal disposant d'une régulation ultérieure séparée ($A_2$, $B_2$, $C_2$) de la tension d'alimentation.

Fig.1

EP 1 236 049 B1

Fig.2